# FASCICULE DE BREVET EUROPEEN

(11) **EP 0 780 968 B1**
(45) Date de publication et mention de la délivrance du brevet: **04.09.2002**
(21) Numéro de dépôt: 96402703.1
(22) Date de dépôt: 12.12.1996
(51) Int. Cl.: H03D 7/16, H04B 1/40

(54) **Terminal de radiocommunication multimode**
Multimoden-Funkendgerät
Multimode radio communications terminal

(30) Priorité: 22.12.1995 FR 9515396
(43) Date de publication de la demande: 25.06.1997
(73) Titulaire: ALCATEL, 75008 Paris (FR)
(72) Inventeur: Auvray, Gérard, 95870 Bezons (FR)
(74) Mandataire: Lamoureux, Bernard

(56) Documents cités:
- WO-A-89/07865
- GB-A- 2 258 776
- 1994 SYMPOSIUM ON VLSI CIRCUITS, 9 Juin 1994, HONOLULU, pages 135-137, XP000501059 WEGER ET AL: "Completely Integrated 1.5GHz Direct Conversion Transceiver"

## Description

La présente invention concerne les radiocommunications numériques et, plus particulièrement, un terminal de radiocommunication susceptible de fonctionner alternativement dans au moins deux systèmes de radiocommunication distincts exploitant des bandes de fréquences relativement proches, c'est-à-dire pouvant être traitées par des mêmes moyens technologiques.

L'invention s'appliquera notamment dans un termina bimode GSM/DECT. On rappelle que le système GSM exploite respectivement les bandes de fréquences 890-916 MHz et 935 960 MHz, pour les deux sens de transmission, tandis que le système DECT exploite la bande de fréquence 1880-1900 MHz.

Dans un terminal de radiocommunication, un oscillateur local produit, à l'émission, une onde à la fréquence d'un canal émission et, à la réception, une onde à la fréquence d'un canal réception. L'onde à la fréquence de canal émission, ou onde locale émission, est modulée par le signal à transmettre pour fournir un signal émission. L'onde à la fréquence de canal réception, ou onde locale réception, sert à démoduler un signal de réception portant l'information à recevoir. Dans le cas de la démodulatio directe, l'onde locale réception est combinée vectoriellement avec le signal réception reçu à l'antenne et fournit un signal d'information en bande de base.

Un terminal, lors de communications différentes doit être accordé sur des canaux émission et réception qui sont chaque fois l'un et l'autre différents, selon les disponibilités locales dun système dans lequel il estexploité. Les ondes locales émission et réception sont donc fournies par au moins une source accordable sur les canaux de ce système. Comme, dans les systèmes de radiocommunication numériques considérés actuellement, la transmission a lieu dans une trame temporelle et est aménagée pour que l'émission et la réception soient séparées dans le temps, une source accordable unique est suffisante.

Dans le cas d'un terminal bimode, les solutions classiques demanderaient soit une source accordable unique, mais à largeur de bande considérablement accrue, soit deux sources accordables distinctes, une par système de radiocommunication.

Le document GB-A-2258776 décrit un terminal de radiocommunication bi-bande et bi-système. Le document WO 89/ 07865 décrit un terminal radio multibande incluant un émetteur- récepteur dont la voie de transmission est à large bande de manière à couvrir deux bandes de fréquences.

On a déjà envisagé, comme décrit dans le document de brevet FR-A-93 07 775, de n'employer qu'une seule source accordable de largeur de bande limitée. Le principe adopté est de mettre d'abord en concordance les bandes de fréquences des deux systèmes, puis d'accorder le terminal sur un canal émission ou réception à l'aide d'une source accordable unique dont la bande de fréquences d'accord est à peu près celle de l'un des systèmes seulement.

Toutefois, cela demande, en réception, l'adjonction d'une chaîne de démodulation intermédiaire ramenant la bande de réception de l'un des systèmes en concordance avec la bande de réception de l'autre système.

La présente invention a donc pour objet un terminal de radiocommunication selon la revendication 1 comportant, comme le précédent, une source accordable d'ondes locales émission et/ou réception constituée par un synthétiseur de fréquences, pour permettre au terminal d'émettre et/ou de recevoir des canaux dans des bandes de fréquences différentes relatives à au moins deux systèmes de radiocommunication, des mélangeurs d'émission et de réception respectivement reliés les uns à un modulateur et les autres à un démodulateur de signaux en bande de base.

Selon une caractéristique de l'invention, ce terminal comporte, en aval de ladite source accordable, constituée par un synthétiseur de fréquences apte à fournir les fréquences d'une bande exploitée par un système, un changeur de fréquence commutable à changement de fréquence fixe, inséré ou non permettant de changer de fréquences, relié à un synthétiseur pour recevoir les fréquences que celui-ci fournit et pour les changer en fréquences d'une autre bande exploitée par un autre système, ceci par une opération, telle qu'une division, une multiplication, une addition ou une soustraction, ainsi que des commutateurs respectivement reliés chacun à un des mélangeurs pour lui transmettre une onde locale provenant soit du synthétiseur, soit du changeur, sous l'action d'un dispositif de commande permettant à un usager de commander le terminal pour accéder aux systèmes.

Dans une forme de réalisation, le changeur est agencé pour permettre d'apporter une division par un facteur déterminé de la fréquence de la source accordable. Ledit facteur est 2, en particulier dans le cas d'un terminal bimode GSM/DECT.

Avantageusement, les sorties de la source accordable et du changeur de fréquence sont suivies chacune d'un déphaseur fournissant deux ondes déphasées de 90° pour la modulation/démodulation de signaux de deux systèmes de radiocommunication appliquant une modulation en quadrature.

Avantageusement encore, deux mélangeurs seulement sont prévus pour la modulation/démodulation des signaux de deux systèmes de radiocommunication, ces mélangeurs recevant les ondes déphasées de 90° de l'un ou de l'autre de deux desdits déphaseurs.

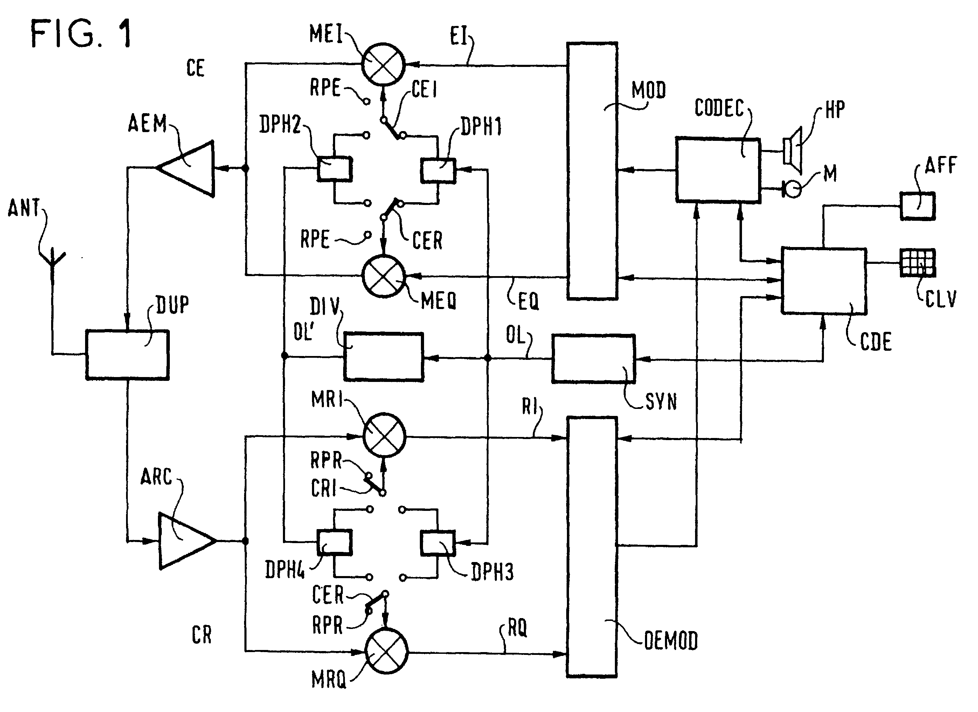

Les différents objets et caractéristiques de l'invention seront détaillés dans la description qui va suivre d'un exemple de mise en oeuvre de l'invention, fourni à titre d'exemple non limitatif, en se référant à la figure annexée qui représente un terminal bimode agencé conformément à l'invention.

Ce terminal bimode, illustré de façon simplifiée par la figure, comprend notamment un clavier CLV et un afficheur AFF, associés à un dispositif de commande CDE, qui permettent à l'usager du terminal de commander le terminal pour accéder à l'un de deux systèmes de radiocommunications au moins, par exemple aux systèmes bien connus GSM et DECT, et qui lui permettent d'échanger des signaux avec ces systèmes, pour obtenir des communications par voie radio. Ces communications peuvent prendre des formes diverses. On a représenté seulement un haut-parleur HP et un microphone M pour les communications vocales associés à un codeur/décodeur de parole CODEC qui est lui-même couplé à un modulateur MOD et à un démodulateur DEMOD.

La chaîne émission CE de ce terminal comprend, outre le modulateur MOD, ayant deux sorties EI et EQ sur lesquelles sont fournis des signaux en bande de base à transmettre, deux mélangeurs émission MEI et MEQ dont les sorties sont conjointement couplées à un amplificateur d'émission AEM, la sortie de ce dernier, atteignant, par un duplexeur DUP une antenne ANT.

La chaîne de réception CR de ce terminal comprend, à partir de l'antenne ANT et du duplexeur DUP, un amplificateur de réception ARC, deux mélangeurs réception MRI et MRQ fournissant à des entrées RI et RQ du démodulateur DEMOD des signaux de réception en bande de base.

A l'émission, les signaux vocaux du micro M, codés sous forme numérique dans le codeur/décodeur CODEC sont mis au format de transmission dans le modulateur MOD qui produit les signaux à transmettre sous forme de symboles émission successifs comprenant chacun deux signaux unitaires émission respectivement fournis sur les sorties EI et EQ. Dans un premier mélangeur émission MEI, le signal unitaire émission EI affecte l'amplitude d'une onde locale émission de phase 0°. Dans un deuxième mélangeur émission MEQ, le signal unitaire émission EQ affecte l'amplitude d'une onde locale émission en quadrature de phase avec la précédente. L'addition de ces deux ondes locales émission ainsi modulées, à l'entrée de l'amplificateur émission AEM fournit le signal radio à transmettre ou signal émission.

A la réception, un signal radio à recevoir, ou signal de réception, après amplification dans l'amplificateur ARC, attaque identiquement les mélangeurs réception MRI et MRQ. Dans un premier mélangeur réception MRI, le signal de réception se combine avec une onde locale réception de phase 0° et cela fournit un signal unitaire réception sur l'entrée RI du démodulateur DEMOD. Dans un deuxième mélangeur réception MRQ, le signal de réception se combine avec une onde locale réception en quadrature de phase avec la précédente et cela fournit un signal unitaire réception sur l'entrée RQ du démodulateur DEMOD. Le démodulateur DEMOD reconnaît les symboles que forment ces signaux unitaires, les démodule et fournit des signaux de parole codés au codeur/décodeur CODEC, lequel produit des sons au travers du haut-parleur HP. Le dispositif de commande CDE est couplé, notamment, au codeur/décodeur CODEC pour prendre connaissance des signaux reçus et pour en commander le fonctionnement.

Bien entendu, ce qui précède est très schématique mais correspond à une technique bien connue et suffira à la compréhension de la présente invention.

Le terminal sous la commande de l'usager, par le moyen de l'afficheur AFF et du clavier CLV, agissant sur le dispositif de commande CDE, ou d'états internes engendrés périodiquement et automatiquement dans le dispositif de commande CDE se trouve à certains moments dans l'état d'émission vers le système de radiocommunication DECT. A ce moment, des commutateurs CEI, CEQ, CRI, CRQ, commandés par le dispositif de commande CDE par des liaisons non représentées, sont dans les positions représentées à la figure. Par ailleurs, le dispositif de commande CDE est en relation avec une source accordable SYN, un synthétiseur de fréquence numérique, par exemple, et lui commande de produire une onde locale émission du système DECT. Cette onde locale est fournie sur la sortie OL du synthétiseur SYN et alimente un déphaseur émission DECT DPH1, lequel fournit au premier mélangeur émission MEI, par un premier commutateur émission CEI dans la position représentée, une onde locale émission DECT de phase 0° et, au deuxième mélangeur émission MEQ, par un deuxième commutateur émission CEQ dans la position représentée, une onde locale émission DECT en quadrature de phase. Les signaux à transmettre modulent ainsi une onde locale émission DECT fournie directement par la source accordable SYN. Des commandes différentes du dispositif de commande CDE permettent de même de moduler d'autres ondes locales émission DECT correspondant à d'autres canaux de la bande de fréquence allouée au système DECT. Cette bande de fréquence s'étend de 1880 à 1900 MHz.

Parallèlement, une liaison bilatérale prévue entre le dispositif de commande CDE et le modulateur MOD, tout comme la liaison bilatérale prévue entre le dispositif de commande CDE et le codeur/décodeur CODEC, font que le codage et le formattage des signaux à transmettre respectent les règles du système DECT.

Par ailleurs, à l'instant que l'on vient de considérer, réservé à l'émission, le terminal ne reçoit pas. D'une façon plus générale, tant que le terminal ne reçoit pas, la chaîne de réception est bloquée. Cela a été illustré, à titre d'exemple de moyen de blocage, par le fait que des commutateurs réception CRI et CRQ sont dans la position représentée, désignée par RPR, dans laquelle les deux mélangeurs réception MRI et MRQ ne reçoivent aucune onde locale.

A d'autres moments, notamment ceux qui sont réservés à la réception, le terminal n'émet pas. La chaîne d'émission est alors bloquée. Cela a été illustré, de même, par le fait que les commutateurs émission CEI et CEQ sont dans une position additionnelle, désignée par RPE, dans laquelle les deux mélangeurs émission MEI et MEQ ne reçoivent aucune onde locale.

Lorsque le terminal doit recevoir, dans le système DECT toujours, les commutateur réception CRI et CRD sont mis par le dispositif de commande CDE dans une position telle qu'ils couplent les mélangeurs réception MRI et MRQ à un déphaseur réception DECT DPH3, lequel reçoit une onde locale réception DECT engendrée dans le synthétiseur SYN sous la commande du dispositif de commande CDE et produit, vers le premier mélangeur réception MRI, par le premier commutateur réception CRI, une onde locale réception DECT déphasée de 0° et, vers le deuxième mélangeur réception MRQ, par le deuxième commutateur réception CRQ, une onde locale réception DECT en quadrature de phase. Les mélangeurs réception MRI et MRQ peuvent ainsi produire les signaux unitaires réception en bande de base RI et RQ vers le démodulateur DEMOD. Ce dernier, couplé par une liaison de commande avec le dispositif de commande CDE, fournit des signaux codés au codeur/décodeur CODEC qui les transforme en signaux vocaux émis par le haut-parleur HP.

Le même terminal bimode représenté par la figure est également prévu pour des communications par un autre système de radiocommunication tel que le système GSM. En dehors du fait que les dispositions relatives au codage et au formattage sont adaptées à ce système différent dans les modulateur MOD, démodulateur DEMOD, codeur/décodeur CODEC, des ondes locales différentes doivent être fournies pour transmettre et recevoir les signaux radio de cet autre système.

A cette fin, le terminal illustré comprend, en aval de ladite source accordable SYN, un changeur de fréquence commutable DIV de sorte que, la source pouvant répondre directement aux besoins d'un système de radiocommunication, comme on vient de le voir, l'insertion dudit changeur de fréquence, la rende capable de répondre aux besoins d'un autre système de radiocommunication, grâce à un changement déterminé de la fréquence produite par ladite source accordable SYN apporté par ledit changeur de fréquence DIV.

Dans l'exemple décrit, ce changeur de fréquence apporte une division de la fréquence fournie par le synthétiseur SYN par un facteur déterminé, ici égal à 2. Il s'agit donc d'un simple étage de division de fréquence, tel qu'une bascule D, qui est connecté à la sortie dy synthétiseur SYN et dont la sortie OL' fournit l'onde locale GSM requise.

On rappelle que le système GSM emploie les bandes de fréquences 890 - 915 MHz et 935 - 960 MHz, c'est-à-dire globalement 890 - 960 MHz.

L'invention prévoit de produire, à l'aide de la source accordable unique qui est le synthétiseur SYN, des fréquences de la bande 1780 - 1920 MHz, pour les diviser par 2 à l'aide du diviseur DIV et ainsi obtenir les fréquences nécessaires de la bande de fréquences 890 - 960 MHz. Plus généralement, l'invention prévoit de produire dans le synthétiseur SYN des fréquences d'une bande concordant sensiblement à celle que fournit directement ce synthétiseur et de changer ces fréquences par une opération telle que la division, la multiplication, l'addition ou la soustraction (il existe des circuits simples accomplissant ces quatre opérations) pour obtenir les fréquences d'une autre bande de fréquence, ou de plusieurs autres bandes de fréquences, dans un terminal multimode. Des moyens de commutation, ici CEI, CEQ, CRI, CRQ, permettent de choisir entre les différentes bandes de fréquences.

Plus précisément, dans l'exemple décrit, le terminal est mis en émission GSM par le dispositif de commande CDE qui place les deux commutateur émission CEI et CEQ dans une position telle que la sortie OL' du diviseur DIV connectée à un déphaseur émission GSM DPH2 fournit une onde locale émission GSM de phase 0° au premier mélangeur émission MEI, et une onde locale émission GSM en quadrature de phase au deuxième mélangeur émission MEQ. L'émission a ainsi lieu, comme décrit précédemment, mais dans le système GSM. Il suffit que le synthétiseur SYN, sous la commande du dispositif de commande CDE fournisse sur sa sortie Ol une fréquence double de celle qui doit porter le canal GSM voulu.

De façon tout-à-fait similaire, un déphaseur réception GSM DPH4 recevant une onde locale OL' issue du diviseur DIV, connecté aux mélangeurs réceptions MRI et MRQ par les commutateurs CRI et CRQ, permet la réception de signaux GSM.

## Revendications

1. Terminal de radiocommunication comportant une unique source accordable d'ondes locales émission et/ou réception constituée par un synthétiseur de fréquences, pour permettre au terminal d'émettre et/ou de recevoir des canaux dans des bandes de fréquences différentes relatives à au moins deux systèmes de radiocommunication, des mélangeurs d'émission et de réception (MRI, MRQ) respectivement reliés les uns à un modulateur (MOD) et les autres à un démodulateur (DEMOD) de signaux en bande de base, **caractérisé en ce que** ce terminal comporte, en aval de ladite source accordable constituée par un synthétiseur de fréquences (SYN) apte à fournir directement les fréquences d'une bande exploitée par un premier système, un changeur de fréquences (DIV), relié audit synthétiseur pour recevoir les fréquences que celui-ci fournit et pour les changer en fréquences d'une autre bande exploitée par un autre système, ceci par une opération telle qu'une division, une multiplication, une addition ou une soustraction, ainsi que des commutateurs (CEI, CEQ, CRI, CRQ) respectivement reliés chacun à un des mélangeurs pour lui transmettre une onde locale provenant soit du synthétiseur (SYN), soit du changeur (DIV), sous l'action d'un dispositif de commande (CDE) permettant à un usager de commander le terminal pour accéder alternativement à l'un ou l'autre des systèmes de radiocommunication.

2. Terminal de radiocommunication conforme à la revendication 1, **caractérisé en ce que** le changeur (DIV) de fréquence apporte une division des fréquences par un facteur déterminé.

3. Terminal de radiocommunication conforme à la revendication 2, **caractérisé en ce que** ledit facteur est 2.

4. Terminal de radiocommunication conforme à la revendication 1,2 ou 3, **caractérisé en ce que** les sorties du synthétiseur (SYN) et du changeur (DIV) sont suivies chacune d'un déphaseur (DPH1 à DPH4) fournissant deux ondes déphasées de 90°, pour la modulation/démodulation des signaux de système de radiocommunication appliquant une modulation en quadrature.

5. Terminal de radiocommunication conforme à la revendication 4, **caractérisé en ce que** deux mélangeurs seulement sont prévus pour la modulation/démodulation des signaux de réception des deux systèmes de radiocommunication, ces mélangeurs recevant les ondes déphasées de 90° de l'un ou de l'autre des deux dits déphaseurs.

## Patentansprüche

1. Funkkommunikationsendgerät, das eine einzige abstimmbare Quelle für lokale Sende- und/oder Empfangswellen, gebildet durch einen Frequenzsynthesizer, umfasst, um dem Endgerät das Senden und/oder Empfangen von Kanälen in verschiedenen, auf wenigstens zwei Funkkommunikationssysteme bezogenen Frequenzbändern zu ermöglichen, und dass Sende- bzw. Empfangsmischer (MRI, MRQ) umfasst, die mit einem Modulator (MOD) bzw. einem Demodulator (DEMOD) für Basisbandsignale verbunden sind, **dadurch gekennzeichnet, dass** das Endgerät hinter der abstimmbaren Quelle, die durch einen Frequenzsynthesizer (SYN) gebildet ist, der in der Lage ist, die Frequenzen eines von einem ersten System genutzten Bandes direkt zu liefern, einen Frequenzwandler (DIV) aufweist, der mit dem Synthesizer verbunden ist, um die Frequenzen, die dieser liefert, zu empfangen und sie auf Frequenzen eines anderen, von einem anderen System benutzten Bandes zu wandeln, und zwar durch eine Operation wie etwa eine Teilung, Multiplikation, Addition oder Subtraktion, sowie Schalter (CEI, CEQ, CRI, CRQ) umfasst, von denen jeder jeweils mit einem der Mischer verbunden ist, um an ihn eine lokale Welle, die von dem Synthesizer (SYN) oder von dem Wandler (DIV) kommt, unter der Wirkung einer Steuervorrichtung (CDE) zu übertragen, die es einem Benutzer ermöglicht, das Endgerät zu steuern, um alternativ auf das eine oder andere der Funkkommunikationssysteme zuzugreifen.

2. Funkkommunikationsendgerät nach Anspruch 1, **dadurch gekennzeichnet, dass** der Frequenzwandler (DIV) eine Teilung der Frequenzen durch einen festgelegten Faktor vornimmt.

3. Funkkommunikationsendgerät nach Anspruch 2, **dadurch gekennzeichnet, dass** der Faktor 2 ist.

4. Funkkommunikationsendgerät nach Anspruch 1, 2 oder 3, **dadurch gekennzeichnet, dass** auf die Ausgänge des Synthesizers (SYN) und des Wandlers (DIV) jeweils ein Phasenschieber (DPH1 bis DPH4) folgt, der zwei um 90° phasenverschobene Wellen für die Modulation/Demodulation der Signale eines eine Quadraturmodulation anwendenden Funkkommunikationssystems liefert.

5. Funkkommunikationsendgerät nach Anspruch 4, **dadurch gekennzeichnet, dass** nur zwei Mischer für die Modulation/Demodulation der Empfangssignale der zwei Funkkommunikationssysteme vorgesehen sind, wobei diese Mischer die um 90° phasenverschobenen Wellen von dem einen oder anderen der zwei Phasenschieber empfangen.

## Claims

1. A radio communication terminal including a single tunable source of send and/or receive local waves consisting of a frequency synthesizer, to enable the terminal to send and/or receive channels in different frequency bands relative to at least two radio communication systems, send and receive mixers (MRI, MRQ) respectively connected the ones to a modulator (MOD) and the others to a demodulator (DEMOD) of baseband signals, **characterized in that** said terminal includes, downstream of said tunable source consisting of a frequency synthesizer (SYN) able to supply directly the frequencies of a band used by a first system, a frequency changer (DIV), connected to said synthesizer to receive the frequencies that it supplies and to change them into frequencies of another band used by another system, by an operation such as a division, a multiplication, an addition or a subtraction, and switches (CEI, CEQ, CRI, CRQ) respectively each connected to one of the mixers to send it a local wave coming either from the synthesizer (SYN) or from the changer (DIV), under the action of a control device (CDE) enabling a user to control the terminal to access one or the other of the radio communication systems alternately.

2. A radio communication terminal claimed in claim 1 **characterized in that** said frequency changer (DIV) divides the frequencies by a particular factor.

3. A radio communication terminal claimed in claim 2 **characterized in that** said factor is 2.

4. A radio communication terminal according to claim 1, 2, or 3, **characterized in that** the outputs of the synthesizer (SYN) and the changer (DIV) are each followed by a phase-shifter (DPH1 to DPH4) supplying two waves phase-shifted by 90° for modulating/demodulating radio communication system signals applying quadrature modulation.

5. A radio communication terminal claimed in claim 4 **characterized in that** only two mixers are provided for modulating/demodulating receive signals of said two radio communication systems, said mixers receiving signals phase-shifted 90° from one or the other of the two said phase-shifters.
